# EUROPEAN PATENT SPECIFICATION

(11) **EP 0 897 136 B1**
(45) Date of publication and mention of the grant of the patent: **20.08.2003**
(21) Application number: 98905652.8
(22) Date of filing: 26.02.1998
(51) Int. Cl.: G03F 7/32

(54) **DEVELOPING SOLUTION FOR PHOTOSENSITIVE RESIN PLATE**
ENTWICKLER FÜR PHOTOEMPFINDLICHE HARZPLATTE
SOLUTION REVELATRICE POUR PLAQUE DE RESINE PHOTOSENSIBLE

(30) Priority: 27.02.1997 JP 4368797; 28.02.1997 JP 4583297
(43) Date of publication of application: 17.02.1999
(73) Proprietor: Toyo Boseki Kabushiki Kaisha, Osaka-shi, Osaka 530-8230 (JP)
(72) Inventor: SHIBANO, Hiroshi-Toyo Boseki Kabushiki Kaisha, Osaka-shiiOsaka 530-8230 (JP); KASHO, Yoshihiro-Toyo Boseki Kabushiki Kaisha, Ohtsu-shi,Shiga 520-0292 (JP)
(74) Representative: VOSSIUS & PARTNER
(86) International application number: JP9800774
(87) International publication number: WO98038550

(56) References cited:
- JP-A- 3 107 853
- JP-A- 4 287 046
- JP-A- 5 107 772
- JP-A- 5 165 209
- JP-A- 8 234 448
- JP-A- 62 089 060
- US-A- 4 692 397
- US-A- 5 035 982

## Description

The present invention relates to a developing method and a developing solution for a photosensitive resin plate, and particularly relates to the use of a developing solution for a photosensitive flexo resin plate, which permits developing with water, and shows superior ink resistance. More particularly, the present invention relates to the use of a developing solution for a photosensitive flexo resin plate, which is capable of increasing the developing rate and image reproducibility even when highly hard water is used for developing a photosensitive resin plate.

Considering working environments and local environments, there have been recently used a number of aqueous development type photosensitive resin plates using water, aqueous surfactant solution, aqueous alkali solution, aqueous acid solution and the like as a developing solution. Also, some photosensitive flexo plates permit use of an aqueous developing solution from the concern for toxicity and safety. This type of plate enables use of an aqueous alkali solution containing sodium carbonate or sodium borate and neutral water, by the introduction of carboxylic group and a salt thereof into the plate composition. Such compositions mentioned above are also associated with serious problems in that a long time of developing is necessary to reach the practical development depth (1 mm), image reproducibility is insufficient as evidenced by the deficient narrow lines and fine dots on developed plates, and the developed resin adheres to the plate as scum and disturbs the images. These problems have prevented prevalence of the water development type photosensitive resin plates.

To solve these problems, developing solutions containing water and a surfactant have been proposed and put to practical use. Of such developing solutions comprising surfactants, nevertheless, those showing alkali property, such as one containing an alkali metal salt of fatty acid, one containing a nonionic surfactant with an inorganic alkali salt and one containing a fatty acid ethanol amide wherein the starting material ethanolamine is somewhat in excess, show faster developing rate, but when water having higher hardness is used as water for a developing solution, the developing rate becomes slower or the resin that has been washed out or polyvalent metal salt of fatty acid adheres to a washed surface of the plate as scum and satisfactory results cannot be achieved.

It is therefore an object of the present invention to provide a developing solution for a photosensitive resin plate, that can increase developing rate and image reproducibility, even when water having higher or lower hardness is used.

In an attempt to solve the above-mentioned problems, the present inventors have repeatedly conducted intensive studies of developing solutions, and reached the present invention. That is, the present invention provides the use of a developing solution for a photosensitive flexo resin plate after exposure, for removing unexposed parts of the plate and which comprises water as a main component and at least one refining agent selected from a substance capable of ion exchange with polyvalent metal ion, a compound capable of forming a chelate compound with polyvalent metal ion, and phosphoric acids.

The photosensitive resin composition to be used in the present invention comprises a polymer having at least one ionic hydrophilic group of the following formula (a), (b), (c) or (d).

**(a) ―COOM**

**(b) ―SO**_{**3**} **M**

**(c) ―SO**_{**4**} **M**

**(d) ―(-O)**_{**3-n**} **PO(OM)**_{**n**}

wherein M is a monovalent or divalent metal atom or an ammonium compound, and n is 1 or 2.

It is exemplified by a polyamide photosensitive resin composition comprising polyamide as an essential component, a polyvinyl alcohol photosensitive resin composition comprising polyvinyl alcohol as an essential component, a polyester photosensitive resin composition comprising low molecular weight unsaturated group-containing polyester as an essential component, an acrylic photosensitive resin composition comprising acrylic low molecular weight monomer as an essential component, a polyurethane photosensitive resin composition comprising polyurethane as an essential component. These photosensitive resin compositions comprise photopolymerizable unsaturated monomer, and photosensitizer, whereby photosensitive property has been afforded.

The aqueous developing type photosensitive resin composition for flexo printing to be used in the present invention is exemplified by a photosensitive resin composition comprising an unsaturated photopolymerizable monomer, a photosensitizer, and a copolymer comprising conjugated diene hydrocarbon and α, β-ethylenic unsaturated carboxylic acid or a salt thereof as essential components, and an unsaturated monoolefin compound (Japanese Patent Unexamined Publication No. 52-134655, Japanese Patent Unexamined Publication No. 53-10648, Japanese Patent Unexamined Publication No. 61-22339), a photosensitive elastomer composition comprising conjugated diene hydrocarbon polymer or a copolymer comprising conjugated diene hydrocarbon and an unsaturated monoolefin compound, a hydrophilic polymer compound or a water swellable polymer compound, a nongaseous unsaturated ethylenic compound and a photopolymerization initiator as essential components (Japanese Patent Unexamined Publication No. 60-211451), a photosensitive resin composition comprising an unsaturated α,β-ethylenic group-containing hydrophobic oligomer, a water swellable elastomer and a photopolymerization initiator as essential components (Japanese Patent Unexamined Publication No. 60-173055), and the like.

Moreover, there are exemplified a photosensitive resin composition comprising hard organic fine particles, for improved properties of a printing plate, such as mechanical strength, impact resilience Japanese Patent Unexamined Publication No. 63-8648), a photosensitive resin composition comprising crosslinking resin fine particles, for imparting aqueous developability, resistance to aqueous ink and improved printability (Japanese Patent Unexamined Publication Nos. 2-175702, 3-228060, 4-293907, 4-293909, 4-294353, 4-340968, 5-32743, 5-150451, 5-204139), a photosensitive resin composition having a two-phase structure, comprising a diazo compound and bichromate in a continuous phase and particles of not more than 10 µm in size in a dispersion phase, for an improved ink receiving property of a printing plate (Japanese Patent Unexamined Publication No. 59-36731).

The above-mentioned compositions are exemplified as a photosensitive resin composition to be used in the present invention. To impart a hydrophobic component with hydrophilicity, it is particularly preferable in the present invention to combine a hydrophobic component with a hydrophilic component in some way to afford a photosensitive flexo plate that can be dispersed in an aqueous developing solution. Specific examples include one comprising, as a main component, a resin obtained by modifying a hydrophobic polymer with a carboxylic acid or a salt thereof; one comprising, as a main component, a mixture of a hydrophobic component comprising a hydrophobic polymer as a main component, and a hydrophilic component comprising a hydrophilic or water swellable polymer as a main component; one comprising, as a main component, a polymer obtained by chemically bonding a hydrophobic polymer and a hydrophilic or water swellable polymer; one comprising, as a main component, a polymer obtained by block copolymerizing a hydrophobic monomer, which is a starting material of the hydrophobic polymer, and a hydrophilic monomer, which is a starting material of the hydrophilic or water swellable polymer.

The hydrophobic polymer exemplified here may include polymers imparting a plate with rubber resiliency, such as poly(1,4-butadiene), poly(1,2-butadiene), acrylonitrile rubber, butadiene acrylonitrile rubber, chloroprene rubber, polyurethane rubber, butadiene-styrene copolymer, styrene-butadiene-styrene block copolymer, styrene-isoprene-styrene block copolymer, polyamide resin, unsaturated polyester resin, butadiene-(meth)acrylic acid copolymer, butadiene-(meth)acrylic acid-acrylate copolymer, silicon rubber, polyoxypropylene glycol, polyoxytetramethylene glycol; and polymers affording a plate with hardness and stability, such as acrylic resins [e.g., poly(methyl (meth)acrylate), poly(ethyl (meth)acrylate), poly(isopropyl (meth)acrylate), poly(n-butyl (meth)acrylate)], polystyrene, polypropylene, polyethylene, chlorinated polyethylene, polyacrylonitrile, poly(vinyl chloride) and poly(vinyl acetate), and copolymers of these, polyurethane resin, polyester resin, polyamide resin, epoxy resin. These may be used alone or in combination. These resins can be modified so that they can react with a monomer or crosslinking agent, or with other polymer.

The hydrophilic or water swellable polymer may be, for example, a polymer of (meth)acrylic acid or a salt thereof; a copolymer of (meth)acrylic acid or a salt thereof and alkyl (meth)acrylate; a copolymer of (meth)acrylic acid or a salt thereof and styrene; a copolymer of (meth)acrylic acid or a salt thereof and vinyl acetate; a copolymer of (meth)acrylic acid or a salt thereof and acrylonitrile; polyvinyl alcohol; carboxymethyl cellulose; polyacrylamide; hydroxyethyl cellulose; polyethylene oxide; polyethyleneimine; polyacrylate, polyvinyl compound, polyurethane, polyureaurethane, polyester, epoxy compound, polyamide and salts thereof and derivatives thereof, all of which have a-COOM group or a-SO₃ M group or a-SO₄ M group or a (-O)₂₋ₙ PO(OM)ₙ (n is an integer of 1-3) group, wherein M means hydrogen atom, monovalent metal atom, divalent metal atom, trivalent metal atom or ammonium compound. The hydrophilic component may be used in combination and may be modified as necessary.

As the starting material of the photosensitive resin composition, a radical polymerizable monomer, a crosslinking agent, a photoreaction initiator, an oxidation stabilizer, a polymerization inhibitor may be added to the aforementioned polymer.

The radical polymerizable monomer is exemplified by styrene, vinyl toluene, chlorostyrene, t-butylstyrene, α-methylstyrene, acrylonitrile, acrylic acid, metacrylic acid, methyl (meth)acrylate, ethyl (meth)acrylate, n-propyl (meth)acrylate, iso-propyl (meth)acrylate, n-butyl (meth)acrylate, iso-butyl (meth)acrylate, sec-butyl (meth)acrylate, t-butyl (meth)acrylate, 2-ethylhexyl (meth)acrylate, n-nonyl (meth)acrylate, n-decyl (meth)acrylate, lauryl (meth)acrylate, n-tridecyl (meth)acrylate, stearyl (meth)acrylate, ethylene glycol mono(meth)acrylate, propylene glycol mono(meth)acrylate, diethylene glycol mono(meth)acrylate, dipropylene glycol mono(meth)acrylate, polyethylene glycol mono(meth)acrylate, polypropylene glycol mono(meth)acrylate, polyethylene glycol monomethyl ether mono(meth)acrylate, polypropylene glycol monomethyl ether mono(meth)acrylate, polyethylene glycol monoethyl ether mono(meth)acrylate, polypropylene glycol monoethyl ether mono(meth)acrylate, n-butoxyethyl (meth)acrylate, phenoxyethyl (meth)acrylate, 2-phenoxypropyl (meth)acrylate, cyclohexyl (meth)acrylate, tetrahydrofurfuryl (meth)acrylate, glycidyl (meth)acrylate, allyl (meth)acrylate, benzyl (meth)acrylate, tribromophenyl (meth)acrylate, 2,3-dichloropropyl (meth)acrylate, 3-chloro-2-hydroxypropyl (meth)acrylate, N,N-diethylaminoethyl (meth)acrylate, N,N-dimethylaminoethyl (meth)acrylate, N-t-butylaminoethyl (meth)acrylate, acrylamide, N,N-dimethylacrylamide, N,N-diethylacrylamide.

The crosslinking agent is exemplified by a compound having two or more radical polymerizable ethylene groups in one molecule, such as ethylene glycol di(meth)acrylate, diethylene glycol di(meth)acrylate, polyethylene glycol di(meth)acrylate, propylene glycol di(meth)acrylate, dipropylene glycol di(meth)acrylate, polypropylene glycol di(meth)acrylate, 1,3-butylene glycol di(meth)acrylate, trimethylolpropane tri(meth)acrylate, 1,4-butanediol di(meth)acrylate, neopentyl glycol di(meth)acrylate, 1,6-hexanediol di(meth)acrylate, 1,9-nonanediol di(meth)acrylate, pentaerythritol di(meth)acrylate, pentaerythritol tri(meth)acrylate, pentaerythritol tetra(meth)acrylate, glycerol di(meth)acrylate, glycerolallyloxy di(meth)acrylate, 1,1,1-trishydroxymethylethane di(meth)acrylate, 1,1,1-trishydroxymethylethane tri(meth)acrylate, 1,1,1-trishydroxymethylpropane di(meth)acrylate, 1,1,1-trishydroxymethylpropane tri(meth)acrylate, triallylcyanurate, triallylisoscyanurate, triallyltrimellitate, diallyl terephthalate, diallyl phthalate, divinyl benzene, polyurethane (meth)acrylate, polyester (meth)acrylate. In addition, a compound having plural reactive functional groups, such as ethylene group, epoxy group, isocyanate group, amino group, hydroxyl group, carboxyl group, in one molecule is exemplified.

Such photosensitive resin composition preferably has a structure wherein a hydrophobic component (polymer) is a particle-like dispersion phase, and a hydrophilic or water swellable component (polymer) surrounds same to form a continuous phase; a structure wherein core shell particles in which a hydrophobic component (polymer) is a core and a hydrophilic or water swellable component (polymer) is a shell, is surrounded by a different hydrophobic component (polymer) to form a continuous phase; a structure wherein a hydrophilic or water swellable component (polymer) is a particle-like dispersion phase and a hydrophobic component (polymer) forms a continuous phase; a structure wherein a hydrophobic component (polymer) and a hydrophilic or water swellable component (polymer) are both continuous phases and entangled with each other in a mosaic-like state; a structure wherein a hydrophobic component (polymer) and a hydrophilic or water swellable component (polymer) are uniformly dissolved; and the like. In the above cases, the continuous phase needs to be not crosslinked when uncured, but the particle state hydrophobic component may or may not be crosslinked when uncured.

The photosensitive resin composition can be produced by various methods, such as a method wherein a dispersion phase component is obtained by emulsion polymerization, suspension polymerization or pulverization of polymers, and the component thereof is solely or together with the continuous component mixed in a kneader or an extruder, followed by molding; a method wherein a hydrophobic component and a hydrophilic component are mixed and kneaded as bulk in a kneader or an extruder to cause phase separation and dispersion, followed by molding; a method wherein a hydrophobic component and a hydrophilic component are mixed and kneaded as bulk in a kneader or an extruder to give a compatible mixture thereof, followed by molding; or other method.

These starting materials and methods are appropriately selected on demand to produce a photosensitive resin composition in conformity with the properties and quality required of the plate.

For example, the properties preferably possessed by a printing plate in terms of printing property are JIS A hardness of 30-80 degrees and impact resilience of not more than 20%.

Such photosensitive resin compositions are cured by ultraviolet rays. The ultraviolet rays to be used for curing has a wavelength of 150-500 nm, particularly 300-400 nm, and the light source to be used is preferably a low pressure mercury lamp, a high pressure mercury lamp, a carbon arc lamp, an ultraviolet fluorescent light, a chemical lamp, a xenon lamp, and a zirconium lamp.

According to the present invention, a photosensitive resin plate, on which a negative film having transparent images has been placed, is exposed to ultraviolet rays from the above-mentioned light source to expose the images to the light, and the non-image parts (unexposed to the light) are removed by the use of a developing solution to give a relief image. The photosensitive resin uncured and removed by dissolution remains in the developing tank in an emulsion or suspension state.

The developing solution of the present invention characteristically contains at least one refining agent selected from a substance capable of ion exchange with polyvalent metal ion, a compound capable of forming a chelate compound with polyvalent metal ion, and phosphoric acids.

The substance capable of ion exchange with polyvalent metal ion, which is the aforementioned refining agent, is a substance insoluble in water and, when it comes into contact in water with ions of elements, such as calcium, magnesium, aluminum, iron, zinc and chromium, which come to have a divalent or more cationic state in water, takes these ions into its atomic or molecular structure to immobilize them, or binds them with the anionic group it has. Specific examples include natural minerals such as mica, kaoline, montmorillonite (acid clay), halloysite, pearlite, bentonite and the like, natural or synthetic sodium aluminosilicate (zeolite), strong acidic or weak acidic cation exchange resins.

The strong acidic cation exchange resin is exemplified by a copolymer mainly of styrene and divinyl benzene, into which a sulfonic group has been introduced, such as the one wherein the sulfonic group is acid type (e.g., -SO₃ H) and the one wherein the sulfonic group is alkali salt type (e.g., -SO₃ Na, -SO₃ K). Examples of the weak acidic cation exchange resin include a copolymer mainly of an acrylic acid or (meth)acrylic acid and divinyl benzene, such as the one wherein the carboxyl group is acid type (e.g., -COOH) and the one wherein the carboxyl group is alkali salt type (e.g., -COONa, -COOK). Moreover, a chelate type ion exchange resin, such as the one wherein a chelate compound [e.g., iminodiacetic acid group (acid type and alkali salt type)] is bound, is exemplified. These cation exchange resins may be copolymerized with other components. In addition, the cation exchange resin may be gel type or MR type depending on the production method.

The substance capable of ion exchange with polyvalent metal ion to be used in the present invention may have any shape, such as bulk, particles, granules or powders. There have been marketed ion exchange resins in spherical particles having a diameter of about 1 mm, and finely divided ion exchange resins.

The content of the substance capable of ion exchange with polyvalent metal ion to be used in the present invention varies depending on the hardness of water to be used and the kind of the substance capable of ion exchange with polyvalent metal ion. In general, it is not less than 0.001% and not more than 20%, preferably not less than 0.01% and not more than 10%, of the entire amount of the developing solution.

The compound capable of forming a chelate compound with polyvalent metal ion, which is a refining agent to be used in the present invention, forms a chelate compound with ions of elements (e.g., calcium, magnesium, aluminum, iron, zinc and chromium) that come to have a divalent or more cationic state in water, and is exemplified by inorganic and organic compounds such as condensed phosphoric acids (e.g., pyrophosphoric acid, triphosphoric acid and polyphosphoric acid); condensed phosphates (e.g., sodium dihydrogendiphosphate, quaternary sodium diphosphate, pentaasodium triphosphate, sodium hexametaphosphate and sodium polyphosphate); aminocarboxylic acids (e.g., iminodiacetic acid, nitrilotriacetic acid, ethylenediaminetetraacetic acid, diethylenetriaminepentaacetic acid, triethylenetetraminehexaacetic acid, 1,2-diaminocyclohexanetetraacetic acid, n-hydroxyethylethylenediaminetriacetic acid, ethylene glycol diethyl ether diaminetetraacetic acid and ethylenediaminetetrapropionic add); alkali metal salts thereof; ammonium salts thereof; polycarbonic acids (e.g., tartaric acid, citric acid, succinic acid, oxalic acid, malonic acid and gluconic acid) and salts thereof; ethyleneamines (e.g., ethylenediamine, diethylenetriamine, triethylenetetramine, tetraethylenepentamine, pentaethylenehexamine and polyethyleneimine); amino acids (e.g., glycine) and salts thereof; oxines and salts thereof; 2-oxyazo compounds and salts thereof; salycilic acids and salts thereof; salicylaldehydes and salts thereof; catechols and salts thereof; β-diketones such as acetylacetone and dibenzoylmethane; dithiooxamide; bipyridines; glyoximes; dyes; polyacrylic acids and salts thereof; various cation exchange resins.

The phosphoric acid which is a refining agent to be used in the present invention is not capable of forming a chelate compound with polyvalent metal ion, but binds with polyvalent metal ion to form a compound insoluble in water. Specific examples include phosphoric acids and salts thereof (e.g., phosphoric acid, sodium dihydrogenphosphate, disodium hydrogenphosphate and trisodium phosphate). While sodium salts have been specifically exemplified, potassium salts, ammonium salts can be also used and the invention is not limited to the above-mentioned examples.

Of the above-mentioned chelating agents and phosphoric adds, phosphoric acids, salts thereof, condensed phosphoric acids and salts thereof, aminocarboxylic acids and salts thereof, all of which form a strong chelate with calcium and magnesium, are preferably used.

While the preferable amount of the above-mentioned compound capable of forming a chelate compound with polyvalent metal ion and/or phosphoric acids varies depending on the hardness of water to be used and the kind of compound capable of forming a chelate compound with polyvalent metal ion, it is not less than 0.001% and not more than 10%, preferably not less than 0.01% and not more than 5%, of the total amount of the developing solution.

The developing solution to be used in the present invention is obtained by adding, to water, at least one refining agent selected from a substance capable of ion exchange with polyvalent metal ion, a compound capable of forming a chelate compound with polyvalent metal ion, and phosphoric acids. In addition, it may contain various additives to accelerate the developing rate or to increase the solubility and dispersibility of the resin that was washed out. The additives include inorganic acids such as hydrochloric acid, sulfuric acid and nitric acid; organic adds such as acetic acid and lactic acid; inorganic alkali such as sodium hydroxide; organic alkali such as amines; acidic or alkaline, inorganic or organic salts such as sodium hydrogensulfate, sodium carbonate, sodium borate, sodium silicate, sodium acetate, sodium methylate; anion, nonionic or cationic surfactants; and anion ion exchange resins, other various additives such as viscosity regulator, dispersion stabilizer, aggregating agent, which are added as necessary.

Examples of anion surfactant include aliphatic carboxylate such as sodium laurate, sodium stearic, sodium oleate; resin soaps such as sodium abietate and sodium rosinate; salts of primary and secondary alkyl sulfates such as sodium lauryl sulfate and triethanolammonium lauryl sulfate; salts of primary and secondary polyoxyethylene alkyl ether sulfates such as sodium polyoxyethylene lauryl ether sulfate and triethanolammonium polyoxyethylene lauryl ether sulfate; alkylbenzenesulfonates such as sodium laurylbenzene sulfonate and sodium stearylbenzene sulfonate: alkylnaphthalene sulfonates such as sodium propylnaphthalene sulfonate and sodium butylnaphthalene sulfonate; polyoxyethylene alkylphenyl ether sulfonates such as sodium polyoxyethylene laurylphenyl ether sulfonate; sulfuric oils such as sulfuric castor oil and sulfuric beef tallow; sulfuric fatty acid esters such as sulfuric butyl oleate; alkylsulfosuccinates represented by sodium dioctylsulfosuccinate; α-olefinsulfonates; hydroxyalkanesulfonates; salts of N-methyl-N-alkyltaurines; salts of N-alkylsulfosuccinic monoamides; salts of fatty acid monoglyceride sulfates; alkyldiphenyl ether disulfonates; salts of alkyl phosphates such as disodium monolauryl phosphate and sodium dilaurylphosphate; salts of polyoxyethylene alkyl phosphates such as disodium mono(polyoxyethylene lauryl ether) phosphate and sodium di(polyoxyethylene lauryl ether) phosphate; condensation products of naphthalenesulfonate and formaline; partial saponicates of styrene-maleic anhydride copolymer; partial saponicates of olefin-maleic anhydride copolymer. While sodium salts have been specifically exemplified, potassium salts, ammonium salts can be also used and the invention is not limited to the above-mentioned examples.

Examples of nonionic activators include polyoxyethylene alkyl ethers such as polyoxyethylene oleyl ether and polyoxyethylene lauryl ether, polyoxyethylene alkylphenyl ethers such as polyoxyethylene nonylphenyl ether and polyoxyethylene octylphenyl ether; polyoxyethylene polyoxypropylene glycols; mono- and diesters of fatty acid and polyethylene glycol such as polyethylene glycol monostearate, polyethylene glycol monoolate and polyethylene glycol dilaurate; esters of fatty acid and sorbitan such as sorbitan monolaulate and sorbitan monoolate; esters of polyoxyethylene adduct of sorbitan and fatty acid such as polyoxyethylenesorbitan monolaurate, polyoxyethylenesorbitan monostealate and polyoxyethylenesorbitan trilaulate; esters of fatty acid and sorbit such as sorbit monopalmitate and sorbit dilaurate; esters of polyoxyethylene adduct of sorbit and fatty acid such as polyoxyethylenesorbit monostearate and polyoxyethylenesorbit dioleate; esters of fatty acid and pentaerythritol such as pentaerythritol monostearate; esters of fatty acid and glycerol such as glycerol monolaurate; sugar and sucrose esters of fatty acids; fatty acid alkanolamides such as lauric acid diethanolamide and lauric acid monoethanolamide; amine oxides such as lauryl dimethylamine oxide; aliphatic alkanolamine such as stearyldiethanolamine; polyoxyethylene alkylamines: triethanolamine esters of fatty acids.

Where necessary, the developing solution may contain other organic solvent that is miscible with water, such as ethanol, isopropanol, cellosolve, glycerol, polyethylene glycol, dimethylformamide, dimethylacetamide, acetone.

The components of these developing solutions may be prepared and added separately when producing a developing solution, or these components may be mixed in advance. Various commercially available products, such as detergents and cleaning agents for clothes, dishes or house, detergents and cleaning agents for industrial use, which may be used alone or in combination, may be also used as long as these components of the developing solution are contained.

The method of developing using the inventive developing solution includes, for example, a method wherein a photosensitive resin composition is immersed in the above-mentioned developing solution of the present invention and the photosensitive resin composition is scrubbed with a brush, if necessary, to remove the uncured parts, a method wherein the inventive developing solution is directly applied to the uncured parts by spraying to remove said parts, a combination of the two methods. The temperature of developing is preferably 10-50°C. The developing solution after developing, which contains a photosensitive resin, may be treated appropriately and wasted, or may be recycled as a developing solution after removing the resin by some method, such as separation by precipitation, passing through a filter, passing through a membrane filter, centrifugation, separation with aggregating agent. In this case, insufficient developing components may be added on demand.

The present invention is described in more detail in the following by referring to examples, to which the present invention is not limited.

The developing rate in the examples and comparative examples means the relief depth after developing for 15 minutes, wherein expressed is the depth of the uncured parts dug out by developing, relative to the cured parts.

### Reference Example 1

Hexamethylene diisocyanate (119.0 parts, manufactured by NIPPON POLYURETHANE INDUSTRY CO., LTD.), dimethylolpropionic acid (62.0 parts, manufactured by Fujii Yoshimichi Co.), polytetramethylene glycol (29.0 parts, G-850, manufactured by HODOGAYA CHEMICAL CO., LTD.), and di-n-butyltin dilaurate (5.0 parts) were dissolved in tetrahydrofuran (300 parts) and the resulting solution was placed in a 1-ℓ flask equipped with a stirrer. The solution was heated to 65°C under continuous stirring and reacted for 2 hr. In a different container, terminal amino-containing acrylonitrile-butadiene oligomer (184.0 parts, Hycar ATBNX 1300 X16, manufactured by Ube Industries, Ltd.) was dissolved in tetrahydrofuran (270 parts). This solution was added into the above-mentioned 1-ℓ flask with stirring at room temperature. The obtained polymer solution was concentrated under reduced pressure to remove tetrahydrofuran to give a polymer having a number average molecular weight of 6,700. This polymer (100 parts) was dissolved in methyl ethyl ketone (100 parts) and a solution of lithium hydroxide (2.4 parts) and magnesium acetate (6.1 parts) in methyl alcohol (100 parts) was added thereto with stirring at room temperature. The mixture was stirred for 30 minutes to give a hydrophilic polymer [1].

The above-mentioned hydrophilic polymer [1] (10 parts), chlorinated polyethylene (45 parts, Elaslen 352 FA, manufactured by SHOWA DENCO K.K.) as a hydrophobic polymer, styrene-butadiene rubber (15 parts, SBR 1507, manufactured by Japan Synthetic Rubber Co., Ltd.), butadiene oligoacrylate (28.5 parts, PB-A, manufactured by Kyoeisha Chemical Co., Ltd.), benzyldimethylketal (1 part, Irgacure 651, manufactured by Ciba-Geigy Limited), and hydroquinone monomethyl ether (0.5 part) were dissolved and dispersed in toluene (40 parts) and water (10 parts), and kneaded in a heating kneader at 105°C. After defoaming, the obtained photosensitive resin composition was heat-pressed in a heat press at 105°C, 100 kg/cm² for one minute between a 125 µm thick polyethylene terephthalate film and the same polyester film having a 2 µm thick polyvinyl alcohol coat layer on one side thereof, so that the polyvinyl alcohol coat layer came into contact with the photosensitive resin, to give a 2.8 mm thick sheet (photosensitive flexo plate).

### Example 1-35 and Comparative Examples 1-8

The photosensitive flexo plate obtained in Reference Example 1 was cut into a size of A2. A suitable negative film having various widths of narrow lines and solid parts was closely adhered. The pattern was printed under a mercury lamp (illumination intensity 50 W/m²) for 10 minutes. The negative film was removed and the plate was developed by scrubbing with a nylon brush in various developing solutions (50 ℓ) shown in Tables 1-4 at 40°C for 15 minutes. After drying at 60°C for 30 minutes, the plate was cured for 10 minutes with the same mercury lamp to give a relief.

The A2 size plates (10 in all) were developed and the developing rates of the first plate and the 10^{th} plate were measured. The adhesion of scum onto the 10^{th} plate was observed. The results are shown in Tables 1-4.

**Table 1**

| | Hardness of water (CaCO₃ mg/L) | Substance capable of ion exchange (amount added, wt%) | Other additive (amount added, wt%) | Developing rate (mm/15 min) | | Adhesion of scum to 10th plate |
|---|---|---|---|---|---|---|
| | | | | 1st plate | 10th plate | |
| Ex. 1 | 500 | A type zeolite (0.5) | ― | 1.0 | 0.9 | No adhesion |
| Ex. 2 | 300 | Strong acidic cation exchange resin H type (0.1) Strong basic anion exchange resin OH type (0.2) | ― | 1.0 | 0.8 | No adhesion |
| Ex. 3 | 300 | A type zeolite (0.2) | Sodium carbonate (0.3) | 1.1 | 1.1 | No adhesion |
| Ex. 4 | 500 | Strong acidic cation exchange resin Na type (0.3) | Sodium borate (0.3) | 1.2 | 1.2 | No adhesion |
| Ex. 5 | 300 | A type zeolite (0.2) | Sodium carbonate (0.5) Sodium borate (0.3) | 1.2 | 1.2 | No adhesion |
| Ex. 6 | 300 | Strong acidic cation exchange resin Na type (0.2) | Sodium carbonate (0.5) Sodium silicate (0.2) | 1.3 | 1.2 | No adhesion |
| Ex. 7 | 300 | Strong acidic cation exchange resin H type (0.2) Strong basic anion exchange resin OH type (0.2) | Sodium carbonate (0.3) | 1.1 | 1.0 | No adhesion |
| Ex. 8 | 800 | Strong acidic cation exchange resin H type (0.5) Strong basic anion exchange resin OH type (0.5) | Sodium carbonate (0.5) Sodium borate (0.3) | 1.2 | 1.2 | No adhesion |
| Ex. 9 | 300 | A type zeolite (0.2) | Fatty acid sodium salt (mixture) (0.5) | 1.2 | 1.1 | No adhesion |
| Ex. 10 | 500 | A type zeolite (0.3) | Fatty acid sodium salt (mixture) (0.5) Sodium carbonate (0.2) | 1.3 | 1.3 | No adhesion |
| Ex. 11 | 300 | Strong acidic cation exchange resin Na type (0.2) | Polyoxyethylene nonylphenyl ether (0.5) Sodium carbonate (0.3) | 1.2 | 1.1 | No adhesion |
| Ex. 12 | 500 | Strong acidic cation exchange resin Na type (0.3) | Lauric acid diethanolamide (1:2)(0.5) | 1.3 | 1.2 | No adhesion |

**Table 2**

| | Hardness of water (CaCO₃ mg/L) | Substance capable of ion exchange (amount added, wt%) | Other additive (amount added, wt%) | Developing rate (mm/15 min) | | Adhesion of scum to 10th plate |
|---|---|---|---|---|---|---|
| | | | | 1st plate | 10th plate | |
| Ex. 13 | 800 | A type zeolite (0.5) | Sodium lauryl sulfate (0.3) Fatty acid sodium salt (0.2) Sodium carbonate (0.2) | 1.3 | 1.2 | No adhesion |
| Ex. 14 | 300 | A type zeolite (0.5) | Sodium oleate (0.5) | 1.0 | 1.0 | No adhesion |
| Ex. 15 | 300 | Strong acidic cation exchange resin H type (0.2) Strong basic anion exchange resin OH type (0.2) | Sodium laurylbenzene sulfonate (0.3) Polyoxyethylene nonylphenyl ether (0.2) Sodium carbonate (0.3) | 1.1 | 1.1 | No adhesion |
| Ex. 16 | 500 | Strong acidic cation exchange resin H type (0.3) Strong basic anion exchange resin OH type (0.3) | Sodium lauryl sulfate (0.3) Fatty acid sodium salt (0.2) Sodium carbonate (0.2) | 1.3 | 1.3 | No adhesion |
| Ex. 17 | 300 | Strong acidic cation exchange resin Na type (0.2) | Fatty acid sodium salt (0.5) Lauric acid diethanolamide (1:2)(0.2) Potassium carbonate (0.2) | 1.3 | 1.3 | No adhesion |
| Co Ex. 1 | 300 | none | Sodium carbonate (0.3) | 0.8 | 0.5 | Partial adhesion |
| Co Ex. 2 | 500 | none | Sodium borate (0.3) | 0.8 | 0.4 | Partial adhesion |
| Co Ex. 3 | 300 | none | Sodium carbonate (0.3) Sodium silicate (0.2) | 1.0 | 0.6 | Partial adhesion |
| Co Ex. 4 | 800 | none | Sodium carbonate (0.3) Sodium silicate (0.2) | 0.9 | 0.5 | Partial adhesion |
| Co Ex. 5 | 800 | none | Fatty acid sodium salt (mixture) (0.5) | 0.5 | 0.3 | Entire adhesion |
| Co Ex. 6 | 800 | none | Fatty acid sodium salt (mixture) (0.5) Sodium carbonate (0.2) | 0.7 | 0.4 | Entire adhesion |
| Co Ex. 7 | 500 | none | Lauric acid diethanolamide (1:2)(0.5) | 0.8 | 0.5 | Partial adhesion |
| Co Ex. 8 | 500 | none | Sodium lauryl sulfate (0.3) Fatty acid sodium salt (0.2) Sodium carbonate (0.2) | 0.9 | 0.5 | Partial adhesion |

In Tables 1 and 2, the amounts of the ion exchange resin are expressed in dry amounts.
A type zeolite ; Silton B (manufactured by MIZUSAWA INDUSTRIAL CHEMICALS, LTD.)
Strong acidic cation exchange resin Na type ; Amberlite CG 120 (manufactured by RHOM AND HAAS, JAPAN)
Strong acidic cation exchange resin H type ; Amberlite CG 120 treated with hydrochloric acid.
Strong basic anion exchange resin OH type ; Amberlite CG 400 (manufactured by ROHM AND HAAS, JAPAN) treated with aqueous sodium hydroxide solution.

**Table 3**

| | Hardness of water (CaCO₃ mg/L) | Compound capable of forming chelate compound or phosphoric acids (amount added, wt%) | Other additive (amount added, wt%) | Developing rate (mm/15 min) | | Adhesion of scum to 10th plate |
|---|---|---|---|---|---|---|
| | | | | 1st plate | 10th plate | |
| Ex. 18 | 500 | Tetrasodium ethylenediaminetetraacetate (0.5) | ― | 1.1 | 1.0 | No adhesion |
| Ex. 19 | 300 | Sodium polyphosphate (0.5) | ― | 1.1 | 1.0 | No adhesion |
| Ex. 20 | 300 | Tetrasodium ethylenediaminetetraacetate (0.1) | Sodium carbonate (0.3) | 1.2 | 1.2 | No adhesion |
| Ex. 21 | 500 | Disodium ethylenediaminetetraacetate (0.2) | Sodium borate (0.3) | 1.2 | 1.2 | No adhesion |
| Ex. 22 | 300 | Pentasodium triphosphate (0.1) | Sodium carbonate (0.5) Sodium borate (0.3) | 1.3 | 1.2 | No adhesion |
| Ex. 23 | 300 | Dipotassium hydrogenphosphate (0.2) | Sodium carbonate (0.5) Sodium silicate (0.2) | 1.3 | 1.2 | No adhesion |
| Ex. 24 | 300 | Sodium citrate (0.5) | Sodium carbonate (0.3) | 1.2 | 1.0 | No adhesion |
| Ex. 25 | 800 | Pentasodium triphosphate (0.2) | Sodium carbonate (0.5) Sodium borate (0.3) | 1.2 | 1.1 | No adhesion |
| Ex. 26 | 300 | Tetrasodium ethylenediaminetetraacetate (0.1) | Fatty acid sodium salt(mixture) (0.5) | 1.1 | 1.1 | No adhesion |
| Ex. 27 | 500 | Tetrasodium ethylenediaminetetraacetate (0.2) | Fatty acid sodium salt (mixture) (0.5) Sodium carbonate (0.2) | 1.3 | 1.2 | No adhesion |
| Ex. 28 | 800 | Disodium ethylenediaminetetraacetate (0.2) | Fatty acid sodium salt (mixture) (0.5) Sodium carbonate (0.2) | 1.3 | 1.1 | No adhesion |
| Ex. 29 | 300 | Disodium ethylenediaminetetraacetate (0.1) | Polyoxyethylene nonylphenyl ether (0.5) Sodium carbonate (0.3) | 1.2 | 1.1 | No adhesion |

**Table 4**

| | Hardness of water (CaCO₃ mg/L) | Compound capable of forming chelate compound or phosphoric acids (amount added, wt%) | Other additive (amount added, wt%) | Developing rate (mm/15 min) | | Adhesion of scum to 10th plate |
|---|---|---|---|---|---|---|
| | | | | 1st plate | 10th plate | |
| Ex. 30 | 500 | Disodium ethylenediaminetetraacetate (0.2) | Lauric acid diethanolamide (1:2)(0.5) | 1.3 | 1.3 | No adhesion |
| Ex. 31 | 800 | Disodium ethylenediaminetetraacetate (0.2) | Sodium laurylsulfate (0.3) laurylsuliate Fatty acid sodium salt (0.2) Sodium carbonate (0.2) | 1.3 | 1.2 | No adhesion |
| Ex. 32 | 300 | Sodium polyphosphate (0.2) | Sodium oleate (0.5) | 1.1 | 1.1 | No adhesion |
| Ex. 33 | 300 | Potassium dihydrogenphosphate (0.1) | Sodium laurylbenzenesulfonate (0.3) Polyoxyethylene nonylphenyl ether (0.2) Sodium carbonate (0.3) | 1.2 | 1.2 | No adhesion |
| Ex. 34 | 500 | Tetrapotassium diphosphate (0.1) | Sodium laurylsulfate (0.3) Fatty acid sodium salt (0.2) Sodium carbonate (0.2) | 1.2 | 1.2 | No adhesion |
| Ex. 35 | 300 | Tetrapotassium diphosphate (0.1) | Fatty acid sodium salt (0.5) Lauric aczid ethanolamide (1:2)(0.2) Potasium carbonate (0.2) | 1.3 | 1.3 | No adhesion |

As is evident from Tables 1 to 4 above, the developing solution used in the present invention could suppress decrease of developing rate even if water with a high hardness was used, and the amount of scum produced by aggregation of the resin that flew out into the developing solution was small. Therefore, the problem of disturbance of images during printing caused by the scum that adhered to the developed printing plate can be eliminated. In addition, the present invention obviates problems caused by the adhesion of scales and scum to the parts in contact with a liquid, such as brushes, pipes and filters of developing machines. Moreover, the developing solution used in the present invention is aqueous, so that it is advantageously treated with ease by known waste treating techniques, such as pH adjustment, addition of adsorbent or aggregating agents, treatment with microorganisms. Therefore, the present invention greatly contributes to the industrial world.

## Claims

1. Use of a developing solution for a photosensitive flexo resin plate after exposure, for removing unexposed parts of the plate,
wherein the developing solution comprises water as a main component, and at least one refining agent selected from the group consisting of a substance capable of ion exchange with polyvalent metal ion, a compound capable of forming a chelate compound with polyvalent metal ion, and phosphoric acids, and wherein the photosensitive resin plate comprises a photosensitive resin composition layer comprising a polymer having at least one ionic hydrophilic group of the following formula (a), (b), (c) or (d):
(a) ―COOM
(b) ―SO₃M
(c) ―SO₄M
(d) (―O)₃₋ₙPO(OM)ₙ
wherein M is a monovalent or divalent metal atom or ammonium compound, and n is 1 or 2.

2. The use of claim 1, wherein the refining agent is a substance capable of ion exchange with polyvalent metal ion.

3. The use of claim 1, wherein the refining agent is a compound capable of forming a chelate compound with polyvalent metal ion.

4. The use of any of claims 1 to 3, wherein the ionic hydrophilic group is represented by -COOM, wherein M is a monovalent or divalent metal atom or ammonium compound.

5. The use of any of claims 1 to 3, wherein the ionic hydrophilic group is represented by (-O)₃₋ₙPO(OM)ₙ, wherein M is a monovalent or divalent metal atom or ammonium compound, and n. is 1 or 2.

6. The use of any of claims 1 to 5, wherein the developing solution further comprises a surfactant.

## Patentansprüche

1. Verwendung einer Entwicklerlösung für eine lichtempfindliche Flexo-Harzplatte nach der Belichtung zur Entfernung nicht belichteter Bereiche der Platte, wobei die Entwicklerlösung Wasser als Hauptbestandteil und mindestens einen Refiner, ausgewählt aus einer Substanz, die zum Ionenaustausch mit einem mehrwertigen Metallion in der Lage ist, einer Verbindung, die zur Bildung einer Chelatverbindung mit einem mehrwertigen Metallion in der Lage ist, und Phosphorsäuren, umfaßt, und
wobei die lichtempfindliche Harzplatte eine lichtempfindliche Harzzusammensetzungsschicht umfaßt, welche ein Polymer mit mindestens einer ionischen hydrophilen Gruppe der folgenden Formel (a), (b), (c) oder (d) umfaßt:
(a) ―COOM
(b) ―SO₃M
(c) ―SO₄M
(d) (―O)₃₋ₙPO(OM)ₙ
wobei M ein einwertiges oder zweiwertiges Metallatom oder eine Ammoniumverbindung ist, und n 1 oder 2 ist.

2. Verwendung nach Anspruch 1, wobei der Refiner eine Substanz ist, die zum Ionenaustausch mit einem mehrwertigen Metallion in der Lage ist.

3. Verwendung nach Anspruch 1, wobei der Refiner eine Verbindung ist, die zur Bildung einer Chelatverbindung mit einem mehrwertigen Metallion in der Lage ist.

4. Verwendung nach einem der Ansprüche 1 bis 3, wobei die ionische hydrophile Gruppe durch -COOM wiedergegeben ist, wobei M ein einwertiges oder zweiwertiges Metallatom oder eine Ammoniumverbindung ist.

5. Verwendung nach einem der Ansprüche 1 bis 3, wobei die ionische hydrophile Gruppe durch (-O)₃₋ₙPO(OM)ₙ wiedergegeben ist, wobei M ein einwertiges oder zweiwertiges Metallatom oder eine Ammoniumverbindung ist, und n 1 oder 2 ist.

6. Verrwendung nach einem der Ansprüche 1 bis 5, wobei die Entwicklerlösung weiter ein Netzmittel umfaßt.

## Revendications

1. Utilisation d'une solution révélatrice pour une plaque flexible de résine photosensible après exposition, pour l'élimination des parties non exposées de la plaque, dans la quelle la solution révélatrice comprend de l'eau en tant que composant principal et au moins un agent d'affinage choisi dans le groupe constitué par une substance capable d'échange d'ions avec un ion métallique polyvalent, un composé capable de former un chélate avec un ion métallique polyvalent, et des acides phosphoriques, et dans laquelle la plaque de résine photosensible comprend une couche d'une composition de résine photosensible comprenant un polymère comportant au moins un groupe hydrophile ionique de formule (a), (b), (c) ou (d) suivante :
(a) ―COOM
(b) ―SO₃M
(c) ―SO₄M
(d) (―O)₃₋ₙPO(OM)ₙ
M étant un atome d'un métal monovalent ou divalent ou un composé d'ammonium et n étant 1 ou 2.

2. Utilisation selon la revendication 1, dans laquelle l'agent d'affinage est une substance capable d'échange d'ions avec un ion métallique polyvalent.

3. Utilisation selon la revendication 1, dans laquelle l'agent d'affinage est un composé capable de former un chélate avec un ion métallique polyvalent.

4. Utilisation selon l'une quelconque des revendications 1 à 3, dans laquelle le groupe hydrophile ionique est représenté par -COOM, M étant un atome d'un métal monovalent ou divalent ou un composé d'ammonium.

5. Utilisation selon l'une quelconque des revendications 1 à 3, dans laquelle le groupe hydrophile ionique est représenté par (-O)₃₋ₙPO(OM)ₙ, M étant un atome d'un métal monovalent ou divalent ou un composé d'ammonium et n étant 1 ou 2.

6. Utilisation selon l'une quelconque des revendications 1 á 5, dans laquelle la solution révélatrice comprend en outre un tensioactif.
